# EUROPEAN PATENT SPECIFICATION

(11) **EP 0 425 294 B1**
(45) Date of publication and mention of the grant of the patent: **29.11.1995**
(21) Application number: 90311724.0
(22) Date of filing: 25.10.1990
(51) Int. Cl.: H01L 23/14

(54) **Two-color molded article for use in circuit formation**
Artikel in zweifarbiger Giessform zur Verwendung bei der Herstellung von Schaltungen
Article moulé à deux couleurs utilisé dans la fabrication de circuits

(30) Priority: 26.10.1989 JP 279041/89
(43) Date of publication of application: 02.05.1991
(73) Proprietor: POLYPLASTICS CO. LTD., Chuo-Ku Osaka-shi Osaka 541 (JP)
(72) Inventor: Nakai, Mikio, Fuji-shi, Shizuoka (JP); Suzuki, Yoshiharu, Matsudo-shi, Chiba (JP)
(74) Representative: Jackson, Peter

(56) References cited:
- EP-A- 0 165 705
- EP-A- 0 264 290
- WORLD PATENTS INDEX LATEST, Section Ch, Week 8731, Derwent Publications Ltd., London, GB; Class A, AN 87-21630 ; & JP-A-62 141 064
- WORLD PATENTS INDEX LATEST, Section Ch, Week 8911, Derwent Publications Ltd., London, GB; Class A, AN 89-08006 ; & JP-A-1 030 722

## Description

This invention relates to a molded article, for use in the formation of electronic circuits, produced by using thermoplastic resin compositions as injection molding materials and molding these resins by two-color injection molding.

The molded article of the invention is formed by two-color injection molding procedure in which a primary side thermoplastic resin is first molded to form a primary molded article of predetermined shape, subjecting the primary molded article to etching and catalyst application as a pretreatment for plating, setting the pretreated article in a second mold having a cavity which is in conformity with the entire shape of a molded article for use in circuit formation, filling with a secondary side thermoplastic resin the space in the second mold cavity unfilled by the primary molded article so as to leave the circuit-formation part of the primary molded article uncovered and integrally molding them by secondary molding. The molded article thus formed is subjected to electroless plating to form a circuit on the uncovered area of the primary side molded article having a circuit formed therein. When the primary side thermoplastic resin contains a plating catalyst, the final product can be obtained by subjecting to the pretreatments and electroless plating a molded article obtained by integrating the molded primary side thermoplastic resin with the molded secondary side thermoplastic resin. However, the adhesion in the molded article between the primary molded article and the secondary side resin is usually so poor that plating solution penetrates through the interface between the primary and secondary side molded resins during the step of electroless plating of the primary side molded article after the two-color molding. This penetration of plating solution causes such problems as corrosion of the formed circuit or peeling at the interface between the primary and secondary sides when the final product is used under severe conditions. These problems have been solved either by improving the adhesion at the interface, for example by improving the resin flow by elevating the cylinder temperature or the injection pressure of a molding machine during the secondary molding, or by reducing differences in the molding shrinkage between the primary side and the secondary side resins, for example by preheating the molded primary side resin to a temperature near the molding temperature of the secondary side resin, setting it in the cavity and performing the secondary molding.

However, these solutions have created further problems such as decreased mechanical strength due to the degradation of the resin, breakage of the primary side molded resin to the elevated injection pressure in the secondary molding and the deformation of the molded primary side resin due to the preheating. Even in those instances in which good adhesion has been achieved between the primary side resin and the secondary side resin and no problem has arisen of maintaining air tightness just after being molded, there has arisen a further problem of delamination due to heat hysteresis during a high-temperature/low-temperature cycle.

With a view to solving the abovementioned problems, the inventors of this invention have investigated means of improving the interfacial adhesion between the molded primary side resin and the molded secondary side resin in a molded article formed by packing and integrally molding the secondary side thermoplastic resin with the molded article of the primary side thermoplastics resin by two-color injection molding. The investigations led to the present invention, wherein a specified liquid crystal polyester resin composition of a very low melt viscosity, namely a melt processable polyester resin composition forming an anisotropic molten phase, has been found to be a very suitable raw material for the secondary side thermoplastic resin. This raw material can give a molded article for use in circuit formation, having improved adhesion between the primary side and the secondary side molded resins, and by further adding a silicone rubber and/or a thermoplastic elastomer to the material the molded article can keep high adhesion even when it is subjected to a load of a high temperature - low temperature heat shock cycle.

Namely, this invention provides a two-color molded article for use in circuit formation, formed by the two-color injection molding process comprising integrally molding a secondary side thermoplastic resin containing an inorganic filler with the molded article of a primary side thermoplastic resin comprising an easily platable resin composition, characterized in that a liquid crystal polyester resin composition containing a liquid crystal polyester of a weight-average molecular weight of 10000 or below as a base resin and having a melt viscosity (at a temperature of 310°C and a shear rate of 1200 sec⁻¹) of 200 P or below is used as the secondary side thermoplastic resin this giving excellent adhesion between the molded article of the primary side thermoplastic resin and the secondary side thermoplastic resin.

The secondary side thermoplastic resin to be used in this invention is a liquid crystal polyester resin composition having a melt viscosity of 200 P or below when measured at a temperature of 310°C and a shear rate of 1200 sec⁻¹, especially, a composition having a melt viscosity of 50 to 200 P. When the melt viscosity exceeds 200 P , imperfect molding is achieved as a result of short shot, etc., while when the melt viscosity is below 50 P, resin flows out of the tip of the nozzle of an injection molding machine to cause problems such as unstable metering.

In order to obtain the liquid crystal polyester resin composition of such a low melt viscosity in this invention, it is necessary to control the kind (weight-average molecular weight) of the liquid crystal polyester resin, the amount of the inorganic filler added, etc. Namely, the liquid crystal polyester resin used should have a weight-average molecular weight of 1000 to 7000. If the liquid crystal resin has a weight-average molecular weight of 10000 or above, short shot occurs, so that the molding must be conducted by elevating the resin temperature or the injection pressure, which sometimes leads to the degradation of the resin and the breakage of the primary side molded article due to the elevated injection pressure. The molecular weight can be determined by gel permeation chromatography and other standard methods which do not involve the formation of polymer solutions, such as the determination of end groups by infra red spectroscopy of a compression-molded film. It is also possible to determine the molecular weight by applying the light scattering method to a solution of a polymer in pentafluorophenol.

The liquid crystal polyester resin material of the secondary side resin to be used in this invention contains an inorganic filler in such an amount as to retain the difficult platability of the resin and to give a melt viscosity of 200 P or below when measured under conditions of a temperature of 310°C and a shear rate of 1200 sec⁻¹. The inorganic filler is not particularly limited and any fibrous, powdery or particulate or platy inorganic substances may be used according to the required duty.

Examples of the fibrous inorganic substance include inorganic fibrous substances such as glass fiber, carbon fiber, asbestos fiber, silica fiber, silica/alumina fiber, alumina fiber, zirconia fiber, boron fiber and potassium titanate fiber.

Examples of the powdery or particulate inorganic substance include carbon black, graphite, silica, quartz powder, glass beads, glass balloons, glass powder, metal oxides such as iron oxide, ferrite, silicon carbide, silicon nitride and boron nitride.

Examples of the platy inorganic substance include mica and glass flakes.

These inorganic fillers may be used alone or in the form of a mixture of at least two of them.

Fillers which are particularly desirably used are fibrous inorganic substances and ground products thereof, and examples thereof include glass fiber and milled glass fiber. The amount of the inorganic filler is 80 % by weight or below, desirably, 30 to 50 % by weight. From the viewpoints of the balance between platability and mechanical properties, milled glass fiber which is in between glass fiber and finely powdered glass is particularly desirable.

In using these inorganic fillers, it is desirable to use, if necessary, a binder or a surface treatment.

This liquid crystal polyester is a high-strength material having a self-reinforcing effect ascribable to its special molecular ordering and has a small dimensional distortion because of its low coefficient of linear expansion and low molding shrinkage. Further, it has a heat resistance of 220 to 240°C in spite of its low melt viscosity and good flow. Further, it is highly chemically stable, is inert to other materials and is desirable as the secondary side thermoplastic resin. Thus, the liquid crystal polyester has excellent properties as the secondary side thermoplastic resin and its adhesive properties can be further improved by adding a silicone rubber and/or a thermoplastic elastomer thereto.

The polyorganosiloxane constituting the silicone rubber to be used in this invention may be one derived by replacing part of the methyl side chains and/or at least part of the chain terminals of, for example, dimethylpolysiloxane by at least one substituent (other than the above reactive functional groups) such as alkyl, aryl, haloalkyl, haloaryl, amino-modified alkyl, mercapto-modified alkyl, epoxy-modified alkyl, carboxyl-modified alkyl or polyether-modified groups, alcohol-modified groups, ester-modified groups or the like.

The silicone rubbers to be used in this invention are desirably powdery or particulate. and examples thereof include a millable silicone rubber formed by kneading an organopolysiloxane of a high degree of polymerization with an inorganic filler and a curing agent and crosslinking the mixture by heat vulcanization and a silicone rubber formed by crosslinking at least one organopolysiloxane having reactive groups by heating, ultraviolet radiation or the like in the presence of a catalyst.

Especially, a powdery or particulate addition type silicone rubber which can be crosslinked by the hydrosilylation addition reaction of an unsaturated group such as a vinyl group with 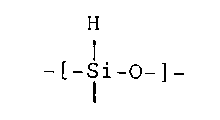
in the presence of a platinum compound catalyst is desirable. As said powdery or particulate silicone rubber, one having a mean particle diameter of 0.1 to 100 »m is desirable, and one having a mean particle diameter of 1 to 20 »m is particularly desirable.

Although the thermoplastic elastometer to be used in this invention is not particularly limited as far as it has heat resistance and good dispersiblity in the secondary side resin and good compatability with it, desirable examples thereof include ethylene/ethyl acrylate copolymers, maleic anhydride-grafted ethylene/ethyl acrylate copolymers, nylon 4,6 and polyamide resin elastomers. When other elastomers are used, it sometimes happens that the elastomers themselves are decomposed because they have poor heat resistance and the melting temperature of the secondary side thermoplastic resin is high. Further, when an elastomer has poor compatability though it has good heat resistance, it is not effective in improving the adhesion because of its poor state of dispersion.

The amount of the silicone rubber or the thermoplastic elastomer in this invention is 0.1 to 10 % by weight based on the total weight of the secondary side thermoplastic resin composition. More particularly, it is desirably 1 to 5 % by weight. When the silicone rubber and the thermoplastic elastomer are to be used together, it is desirable that the amount thereof should not exceed 15 % by weight based on the total weight of the composition.

Because the silicone rubber and the thermoplastic elastomer are added to the secondary side thermoplastic resin of this invention not for the purpose of reacting them with the liquid secondary side thermoplastic polyester, chemically inert ones are desirable. When these silicone rubber and thermoplastic elastomer are added to the liquid crystal polyester, the obtained composition is desired to take the so-called sea-island structure.

Further, the secondary side composition of this invention may contain other thermoplastic resins as auxiliaries within the range not detrimental to the intended object of this invention within the scope of this invention.

The thermoplastic resins to be used in this case are not particularly limited and examples thereof include polyolefins such as polyethylene and poloypropylene, polyacetals (homo- and co-polymers), polystyrene, polyvinyl chloride, polyacrylate and copolymer thereof, polycarbonate, ABS, polyphenylene oxide, polyphenylene sulphide and fluorroesin. These thermoplastic resins may be used also in the form of a mixture of at least two of them.

According to the required duty, it is also appropriate to add optionally well-known additives for ordinary thermoplastic and thermosetting resins, namely, plasticizers, stabilizers such as antioxidants and ultraviolet absorbers, antistatic agents, surface treatments, surfactants, flame retardants, colorants such as dyes and pigments, parting agents and lubricating agents for improving flow and mold release characteristics, and crystallization accelerators (nucleators).

The primary side thermoplastic resin to be used in this invention is an easily platable thermo-plastic resin, and is not particularly limited as far as it is a thermoplastic resin which can be bonded to metal by plating and can be surface-treated to have an adhesion to a plating metal above a certain level. It may be suitably selected according to the condition of use of the molded article. Because it is necessary for the purpose of use that the molded article for use in circuit formation meet requirements such as solderability, durability and mechanical properties, it is desirable that the molded primary side resin is a material which is heat-resistant, has mechanical strengths, good dimensional stability and a coefficient of linear expansion very close to that of a metal, and does not cause facile peeling of the plating metal.

Examples of the primary side thermoplastic resin suitable in this invention from this viewpoint include liquid crystal polyesters (melt-processable polyesters which can exhibit anisotropy when melted), polysulphones, polyether sulphones, polyether imides, polyphenylene sulphides and polyether ketones.

Especially, the liquid crystal polyesters can form a fine wire circuit because of good moldability and are thermoplastic resins with excellent properties such as rigidity, heat distortion resistance and dimensional stability. Further they are materials which are most suitable for the primary side molded article of this invention in respect that a liquid crystal polyester resin composition is used as the secondary side thermoplastic resin in this invention.

A liquid crystal polyester suitably used in this invention generally has a weight-average molecular weight of about 2000 to 200000, desirably, about 10000 to 50000, particularly desirably, about 20000 to 25000. On the other hand, a suitable aromatic polyester amide generally has a molecular weight of about 5000 to 50000, desirably, about 10000 to 30000, for example, 15000 to 17000.

The abovementioned aromatic polyester and polyester amide generally have an inherent viscosity (I.V.) of at least about 2.0 dl/g, for example, about 2.0 to 10.0 dl/g when dissolved in pentafluorophenol at 60°C in a concentration of 0.1 % by weight.

A liquid crystal polyester in general is platable with difficulty, but it is easily made platable so as to be used as the primary side thermoplastic resin by adding to the resin at least one inorganic filler selected from the group consisting of the Group II elements of the periodic table and oxides, sulphates, phosphates, silicates and carbonates thereof, aluminium, silica, tin, antimony, bismuth and oxides thereof, and palladium chloride.

Examples of the inorganic filler include oxides such as magnesium oxide, calcium oxide, barium oxide and zinc oxide; magnesium phosphate; calcium phosphate; barium phosphate; zinc phosphate; magnesium pyrophosphate; calcium pyrophosphate; sulphates such as barium sulphate; silicates such as magnesium silicate,, calcium silicate, aluminium silicate, kaolin, talc, clay, diatomaceous earth and wollastonite; magnesium carbonate; calcium carbonate; barium carbonate; and zinc carbonate.

It is also possible to add the above mentioned fibrous, powdery or particulate or platy inorganic filler together with the above inorganic filler to the primary side thermoplastic resin. A metallic fiber or foil can also be used. It is also possible to use other thermoplastic resins, additives, etc., used in the secondary side resin.

The liquid crystal polyesters desirably used as both of the primary side and the secondary side thermoplastic resins in this invention are melt-processable polyesters which can assume a molten state in which the polymer molecular chains are regularly ordered in parallel. A state in which molecules are so ordered is sometimes referred to as a liquid crystal state or a nematic phase of a liquid crystal substance. The molecule of such a polymer is generally long and flat, has a considerably high rigidity along the major molecular axis and is usually composed of a plurality of chain extending bonds lying in a coaxial or parallel relation.

The nature of an anisotropic molten phase can be confirmed by the conventional polarization test performed by using crossed polariziers. More particularly, an anisotropic molten phase can be confirmed by using a Leitz polarization microscope and observing a molten sample mounted on a Leitz hot stage in a nitrogen atmosphere at a magnification of 30 X. Even when the polymer of this invention is in a static molten state when observed between crossed polarizers, it can transmit a polarized light and exhibits optical anisotropy.

The liquid crystal polymer suitable for use in this invention has a tendency toward being substantially insoluble in an ordinary solvent, so that it is unsuitable for solution processing. However, these polymers, as already mentioned, can be easily processed by usual melt processing techniques.

The polymer showing an anisotropic molten phase, used in this invention, is desirably an aromatic polyester or an aromatic polyester amide, and a polyester partially comprising both of an aromatic polyester and an aromatic polyester amide in the same molecule is a desirable example. A particularly desirable example is a liquid crystal aromatic polyester or aromatic polyester amide containing at least one compound selected from the group consisting of an aromatic hydroxy carboxylic acid, an aromatic hydroxy amine and an aromatic diamine as the constituent.

More particularly, examples thereof include
1) a polyester mainly consisting of at least one member selected from an aromatic hydroxy carboxylic acid and derivatives thereof,
2) a polyester mainly consisting of
   (a) at least one member selected from an aromatic hydroxy carboxylic acid and derivatives thereof,
   (b) at least one member selected from among an aromatic hydroxy carboxylic acid, an alicyclic dicarboxylic acid and derivatives thereof, and
   (c) at least one member selected from among an aromatic diol, an alicyclic diol, an aliphatic diol and derivatives thereof,
3) a polyester amide mainly consisting of
   (a) at least one member selected from an aromatic hydroxy carboxylic acid and derivatives thereof,
   (b) at least one member selected from among an aromatic hydroxy amine, an aromatic diamine and derivatives thereof, and
   (c) at least one member selected from among an aromatic dicarboxylic acid, an alicyclic dicarboxylic acid and derivatives thereof, and
4) a polyester amide mainly consisting of
   (a) at least one member selected from an aromatic hydroxycarboxylic acid and derivatives thereof,
   (b) at least one member selected from among an aromatic hydroxy amine, an aromatic diamine and derivatives thereof,
   (c) at least one member selected from among an aromatic dicarboxylic acid, an alicyclic dicaraboxylic acid and derivatives thereof, and
   (d) at least one member selected from among an aromatic diol, an alicyclic diol, an aliphatic diol and derivatives thereof.

If necessary, a molecular weight modifier may be used together with the above constituents.

Desirable examples of particular compounds which constitute the liquid crystal polyester of this invention include naphthalene compounds such as 2,6-naphthalene-dicarboxylic acid, 2,6-dihydroxynaphthalene, 1,4-dihydroxynaphthalene and 6-hydroxy-2-naphthoic acid; biphenyl compounds such as 4,4′-diphenyldicarboxylic acid and 4,4′-dihydroxybiphenyl; compounds represented by the following general formulae (I), (II) and (III): 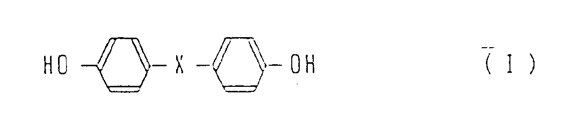 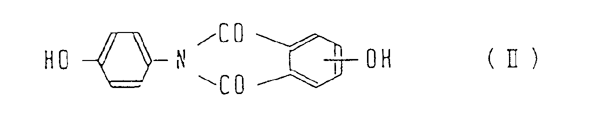 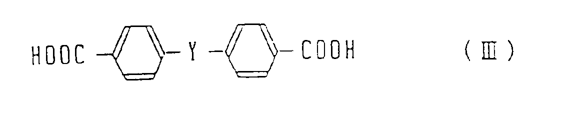
wherein
X is a group selected from among an alkylene (C₁-C₄), an alkylidene, -O-, -SO-, -SO₂, -S- and -CO-, and
Y is a group selected from -(CH₂)ₙn- (wherein n is 1 to 4) and -O(CH₂)ₙO- (wherein n is 1 to 4),
p-substituted benzene compounds such as p-hydroxybenzoic acid, terephthalic acid, hydroquinone, p aminophenol and p-phenylenediamine and ring-substituted derivatives thereof (wherein the substituent is selected from among chloro, bromo, methyl, phenyl and 1-phenylethyl); and m-substituted benzene compounds such as isophthalic acid and resorcinol.

The liquid crystal polyester used in this invention may contain, in addition to the abovementioned constituents, a polyalkylene terephthalate which does not exhibit any anisotropic molten phase as part of the same molecular chain. The number of carbon atoms of the alkyl group in this case is 2 to 4.

Preferred examples of the liquid crystal polyester are those containing, among the abovementioned constituents, at least one compound selected from among a naphthalene compound, a biphenyl compound and a p-sustituted benzene compound as the essential component. Particularly desirable examples among the p-substituted benzene compounds are p-hydroxybenzoic acid, methylhydroquinone and 1-phenylethylhydroquinone.

Examples of the compounds having esterifiable functional groups as constituents and the desirable polyesters forming an anisotropic molten phase to be used in this invention are described in Japanese Patent Publication No 36633/1988.

This invention relates to a two-color molded article for use in circuit formation, which is formed by molding the secondary side thermoplastic resin with the molded primary side thermoplastic resin constituted as abovementioned and wherein the liquid crystal polyester of the secondary side thermoplastic resin containing an inorganic filler such as glass fiber, milled glass fiber or an inorganic powder has decreased anisotropy and gives a molded article having a very low coefficient of linear expansion which is the same in all directions irrespective of the resin flow during molding and having heat resistance and heat shock resistance.

When a silicone rubber and/or a thermoplastic elastomer are added to the liquid crystal polyester, the molded article of this invention has a decreased post shrinkage and an improved adhesion between the primary side and secondary side resins, and retains the reliability of a product for a long time.

### Examples

This invention will now be described in more detail with reference to the following non-limiting Examples. Reference is made in the Examples to the accompanying drawings, in which:
Figure 1(a) is a perspective view of a two-color molded article prepared in the Examples,
Figure 1(b) is an enlarged view of the plated part (primary side thermoplastic resin) of said article, and
Figure 2 is a perspective view representing the state in which a lid is laid on said molded article.

The reference numerals in these figures indicate the following components:
1: primary side thermoplastic resin
2: secondary side thermplastic resin
3: glass lid.

### Examples 1 to 10 and Comparative Examples 1 and 2

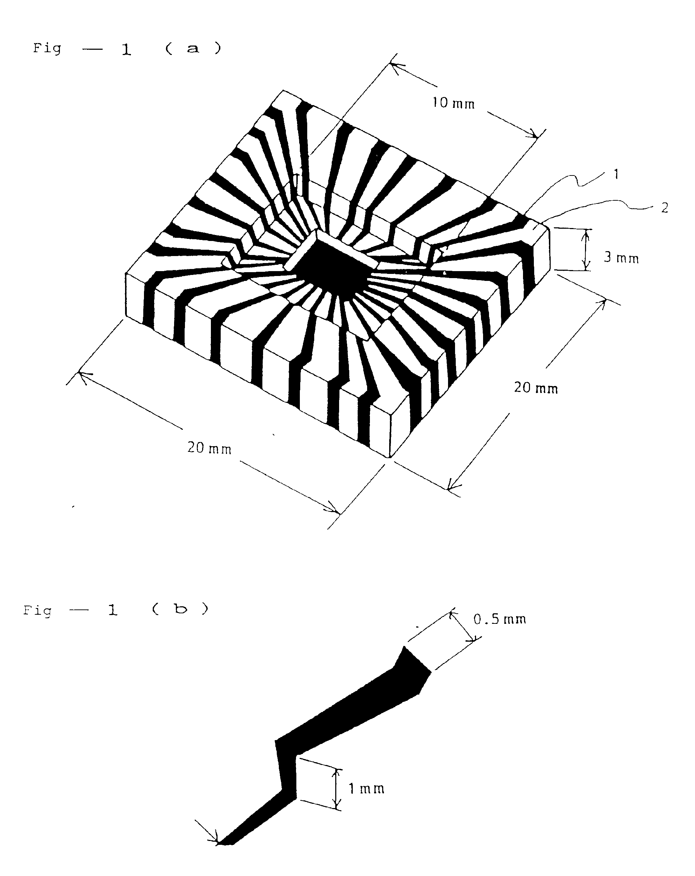

Each of the following seven liquid polyester resins was mixed with an inorganic filler, etc. in a composition ratio as specified in Table 1 to form the primary side thermoplastic resin composition or the secondary side thermoplastic resin composition. The thus-obtained compositions were pelletized at 300 to 320°C in a usual manner and these pellets were molded into the shapes shown in Figure 1 by two-color molding to evaluate the molded articles thus formed. The cylinder temperature of the injection molding machine used was set at 300°C. Table 1 gives the results of measurement.

The liquid crystal polyesters used in the Examples were those having the following structural units: 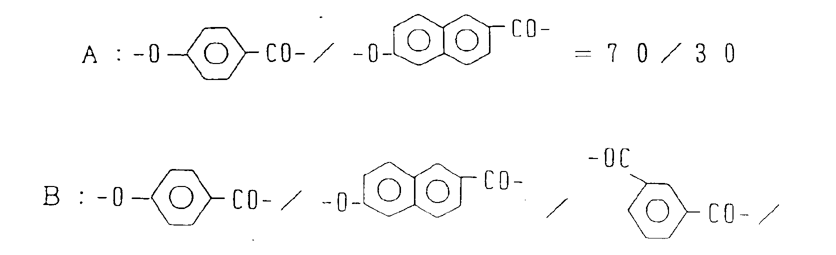 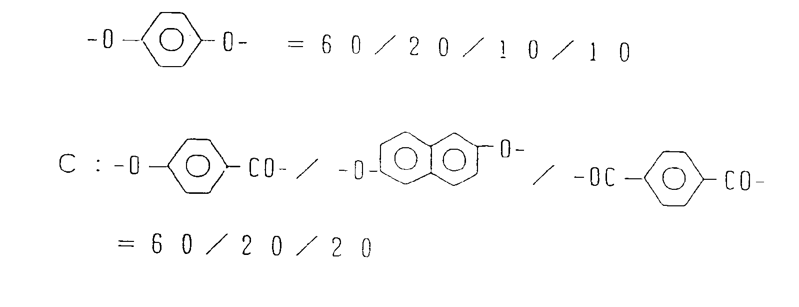 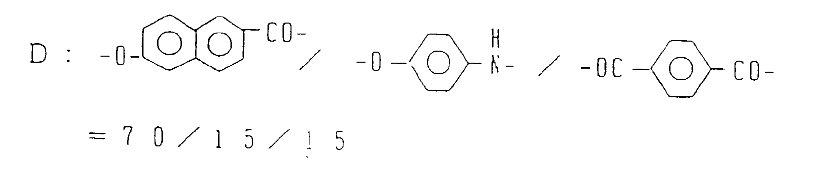 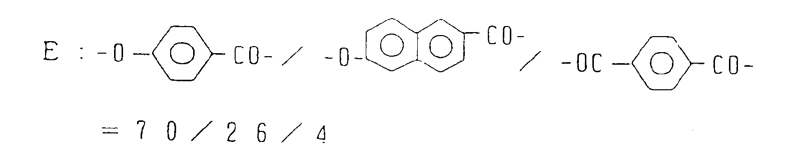 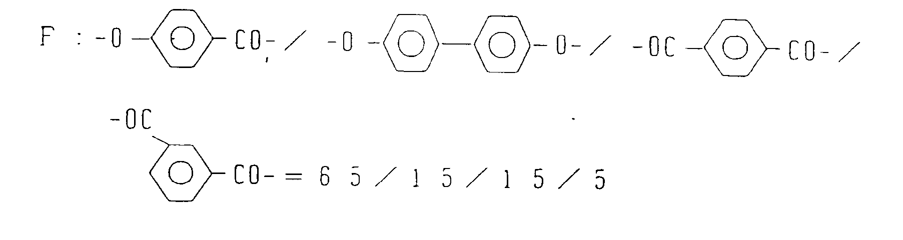 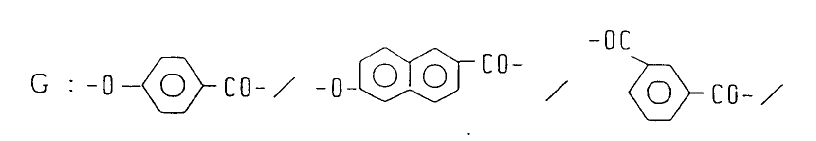 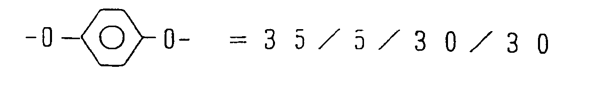
(The above numbers represent molar ratios)

The silicone rubber A used here was a powdery or particulate (mean particle diameter of 8 »m) silicone rubber prepared by crosslinking a vinyldimethylpolysiloxane with a dimethylpolysiloxane having a 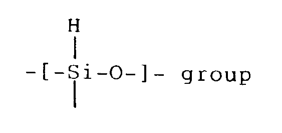
by addition reaction in the presence of a platinum compound catalyst. The silicone rubber B was one derived by replacing part of the methyl groups of the silicone rubber A by epoxy groups.

The methods for the measurement of the properties described in the following Examples and the evaluation methods were as follows:

### Measurement of Weight-Average Molecular Weight

A gel permeation chromatograph composed of a liquid feed pump, a sample injector, a high temperature thermostatic chamber, a separator column, a differential refractive index detector (DRI), a small-angle laser beam scattering photometer, a personal computer for processing control data, etc was used to feed about 150 »l of a 0.1 wt. % polymer solution prepared by dissolving pellets of a liquid crystal polyester resin composition in pentafluorophenol through the injector to the apparatus uniformly set at 60°C, separating the polymer fractions through a polystyrene gel treatment by utilizing the difference in molecular weight, sending the separated fractions to DRI and processing the obtained data to determine the molecular weight.

### Ink Penetration Test

A molded article shown in Figure 1 was immersed in an ink solution (a methanolic solution of red ink) for 5 minutes to the depth of a half of the thickness of the article with the upside thereof being directed upward to observe the presence or absence of penetrated ink in the area of contact between the molded primary side resin and the molded secondary side resin at the recessed central part of the molded article under a microscope.

### Gross Leak Test

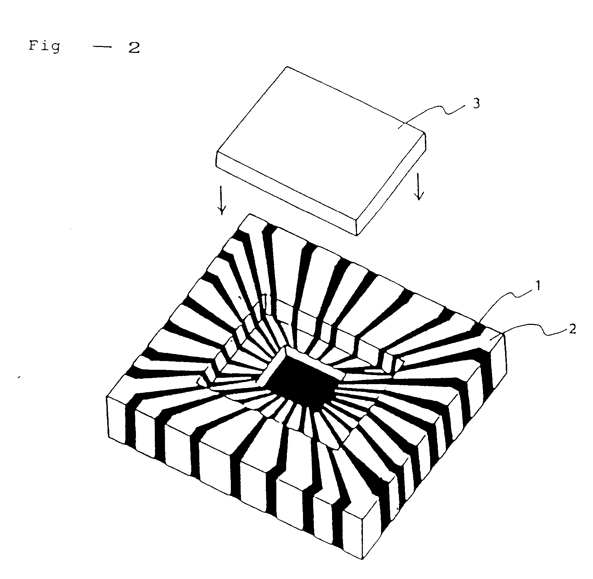

As shown in Figure 2, the recess of a two-color molded article of Figure 1 was covered with a glass plate by using an epoxy adhesive and the covered article was immersed in an inert liquid (Fluoroinert F40, a product of 3M)(at 125°C) to evaluate the adhesion between the primary side and secondary side molded articles in terms of the emergence or non-emergence of bubbles from the area of contact between the primary side and the secondary side resins and the time required for the first bubble to be recognized. The case where no bubble was recognized after immersion for 30 minutes was designated as "no".

A sample prepared by drying the same sample by heating at 150°C for 1 hour and immersing it in a soldering bath at 260°C for 10 seconds was subjected to the similar gross leak test. The case where no bubble was recognized after immersion for 10 minutes was taken as a measure of adhesion, and this state was designated as "no".

### Examples 11 to 13

Molded articles were prepared for evaluation in the same manner as that of Examples 1 to 10 except that polyphenylene sulphide (PPS) or polyethylene terephthalate (PET) was used instead of the liquid crystal polyesters of Examples 1 to 10 as the base resin to prepare primary side thermoplastic resin compositions listed in Table 2. Table 2 shows the results of measurement.

### Examples 14 to 21

Molded articles of the compositions specified in Table 3 were prepared for evaluation in the same manner as that of Examples 1 to 10 by using liquid crystal polyesters B,C and D as the primary side thermoplastic resins and liquid crystal polyester A as the secondary side thermoplastic resin. Table 3 gives the results of measurement.

### Comparative Example 3

Preparation of molded articles was attempted in the same manner as that of Examples 14 to 16 except that liquid polyester A of a high weight-average molecular weight (MW : 25000) was used as the secondary side thermoplastic resin. However, the solution viscosity of the secondary resin composition was 691P, so that the molding of the secondary side resin was impossible.

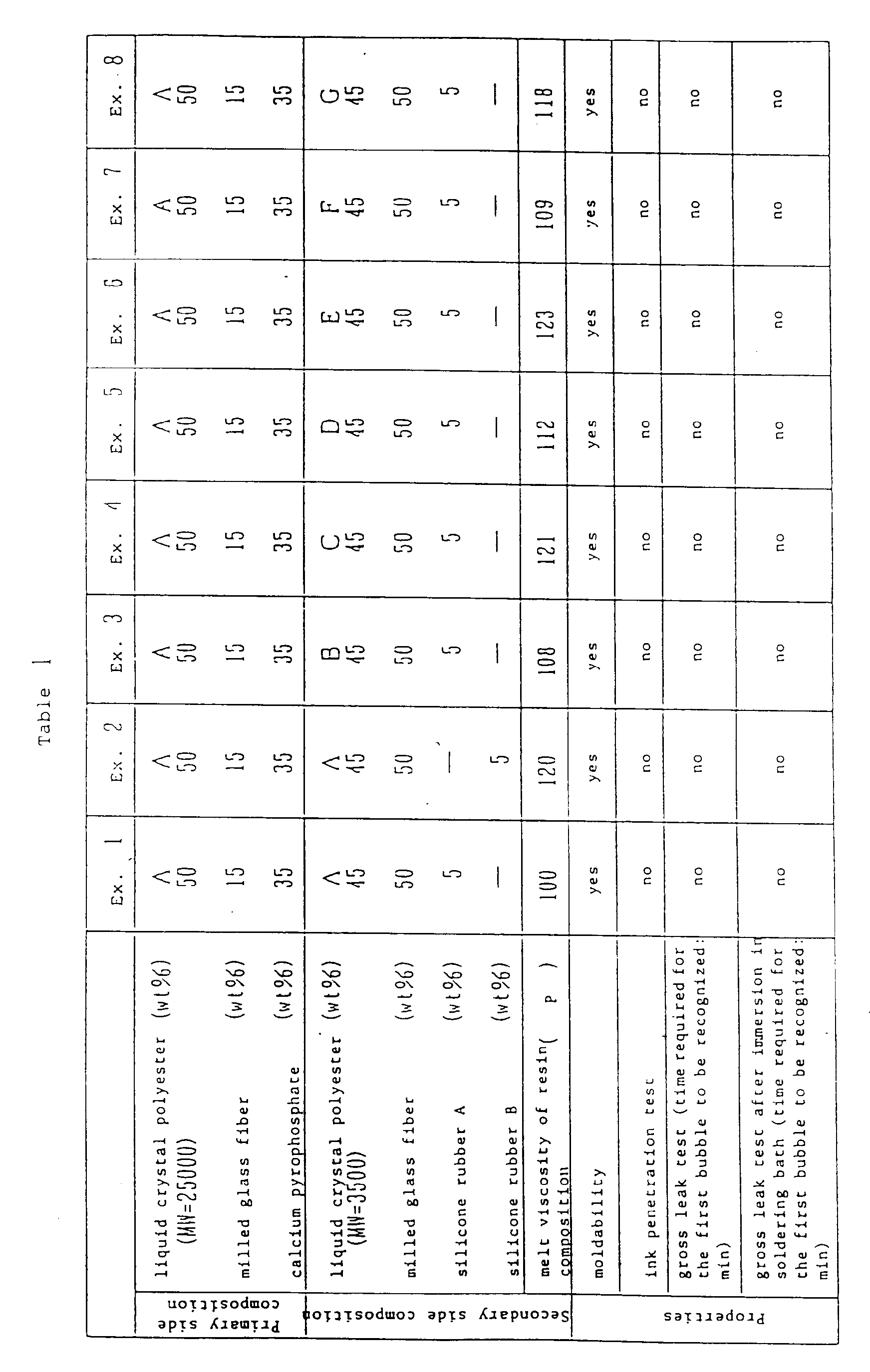

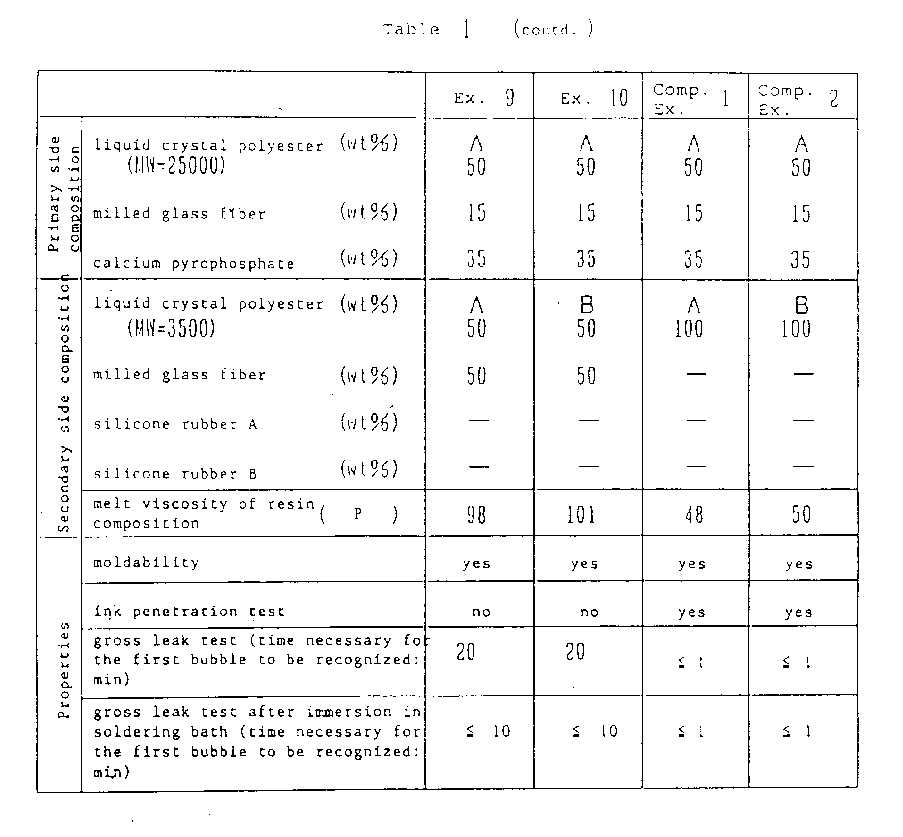

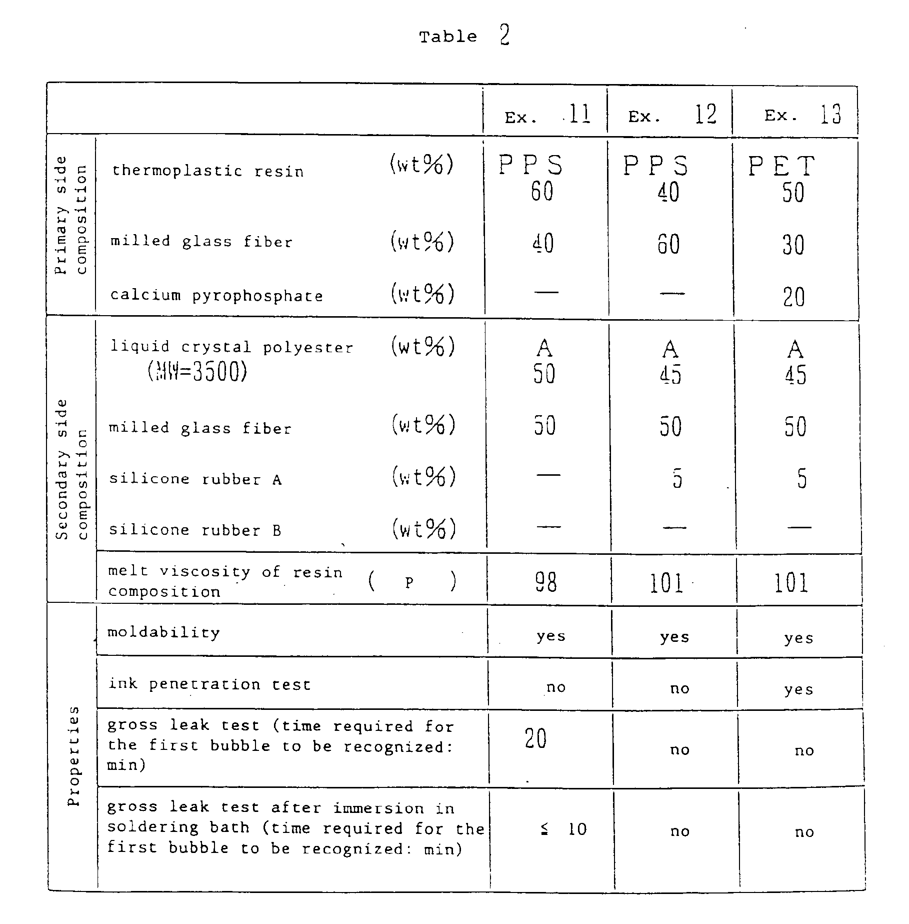

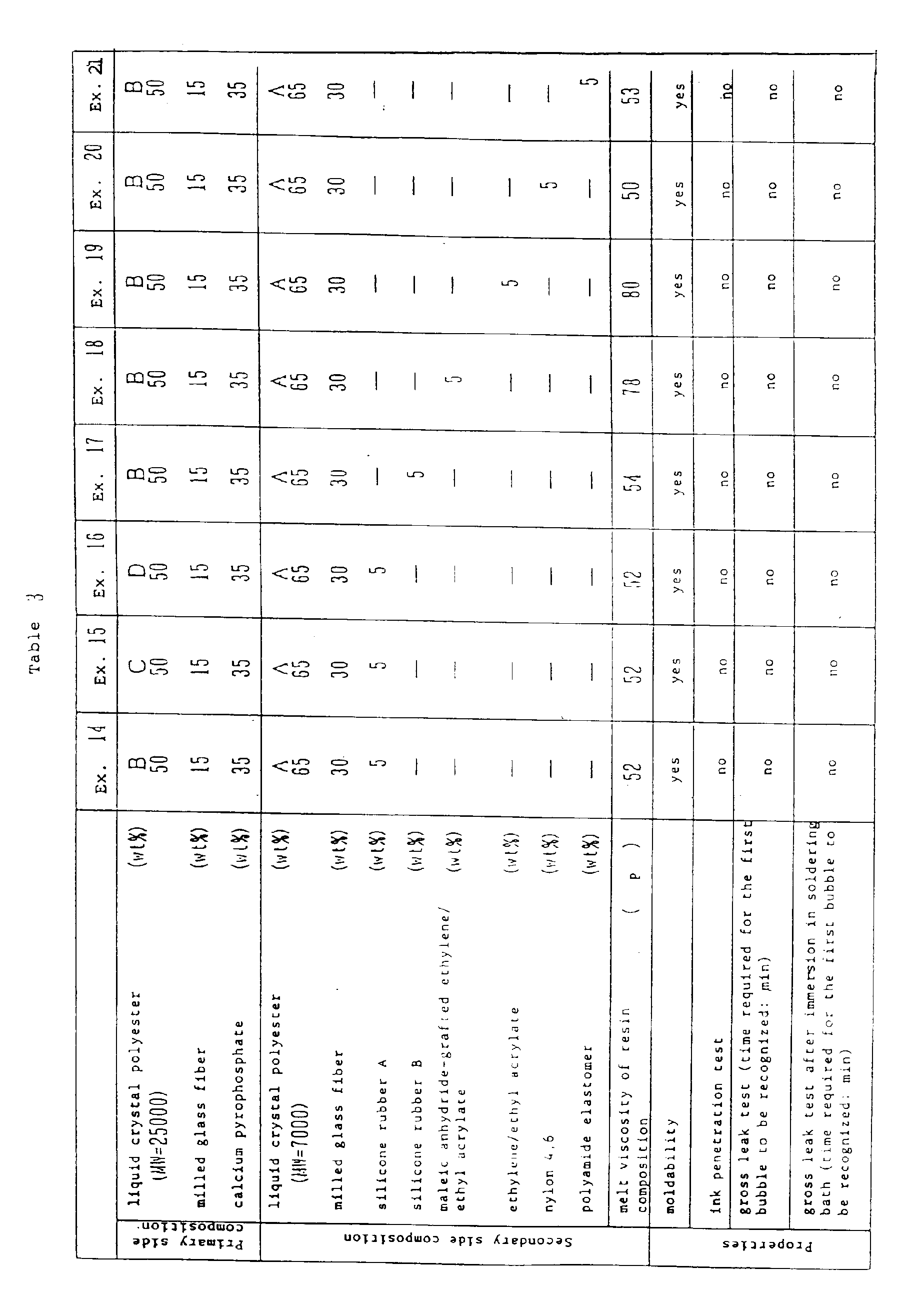

## Claims

1. A two-color molded article for use in circuit formation, formed by the two-color injection molding process comprising integrally molding a secondary side thermoplastic resin containing an inorganic filler with the molded article of a primary side thermoplastic resin comprising an easily platable resin composition, characterized in that a liquid crystal polyester resin composition containing a liquid crystal polyester of a weight-average molecular weight of 10000 or below as a base resin and having a melt viscosity (at a temperature of 310°C and a shear rate of 1200 sec⁻¹) of 200 P or below is used as the secondary side thermoplastic resin this giving excellent adhesion between the molded article of the primary side thermoplastic resin and the secondary side thermoplastic resin.

2. A two-color molded article according to claim 1, wherein the primary side thermoplastic resin is selected from liquid crystal polyesters, polysulphones, polyether sulphones, polyether imides, polyphenylene sulphides and polyether ketones.

3. A two-color molded article according to claim 1 or claim 2, wherein the primary side thermoplastic resin contains an inorganic filler.

4. A two-color molded article according to any preceding claim, wherein the secondary side thermoplastic resin contains 0.1 to 10 wt% (based on the whole composition) of a silicone rubber and/or a thermoplastic elastomer.

5. A two-color molded article according to claim 4, wherein the secondary side thermoplastic resin contains a powdery or particulate silicone rubber.

6. A two-color molded article according to claim 5, wherein the secondary side thermoplastic resin contains silicone rubber having a mean particle diameter of 0.1 to 100 »m.

7. A two-color molded article according to claim 4, wherein the secondary side thermoplastic resin contains a thermoplastic elastomer selected from ethylene/ethyl acrylate copolymer resins, maleic anhydride-grafted ethylene/ethyl acrylate copolymer resins, nylon 4,6 and polyamide resin elastomers.

8. A two-color molded article according to any preceding claim, wherein the molded article of the primary side is one pretreated for plating.

9. A two-color molded article according to any preceding claim, wherein the liquid crystal polyester is selected from an aromatic polyester, an aromatic polyester amide and a polyester partially comprising both of an aromatic polyester and an aromatic polyester amide in the same molecule.

10. A two-color molded article according to claim 9, wherein the liquid crystal polyester is a liquid crystal aromatic polyester or aromatic polyester amide containing at least one compound selected from the group consisting of an aromatic hydroxy carboxylic acid, an aromatic hydroxy amine and an aromatic diamine.

## Patentansprüche

1. Zweifarbiger geformter Gegenstand zur Verwendung bei der Schaltungsbildung, der durch das Zweifarben-Spritzgußverfahren gebildet ist, umfassend das integrale Formen eines thermoplastischen Harzes der sekundären Seite, das einen anorganischen Füllstoff enthält, mit dem geformten Gegenstand aus einem thermoplastischen Harz der primären Seite, das eine leicht plattierbare Harzzusammensetzung umfaßt, dadurch gekennzeichnet, daß eine Flüssigkristallpolyester-Harzzusammensetzung, die einen Flüssigkristallpolyester mit einem Gewichtsmittel des Molekulargewichts von 10 000 oder darunter als Grundharz enthält und eine Schmelzviskosität (bei einer Temperatur von 310°C und einer Schergeschwindigkeit von 1200 s⁻¹) von 200 P oder darunter besitzt, als thermoplastisches Harz der sekundären Seite verwendet wird, wobei dies eine ausgezeichnete Haftung zwischen dem geformten Gegenstand aus dem thermoplastischen Harz der primären Seite und dem thermoplastischen Harz der sekundären Seite ergibt.

2. Zweifarbiger geformter Gegenstand gemäß Anspruch 1, wobei das thermoplastische Harz der primären Seite aus Flüssigkristallpolyestern, Polysulfonen, Polyethersulfonen, Polyetherimiden, Polyphenylensulfiden und Polyetherketonen ausgewählt ist.

3. Zweifarbiger geformter Gegenstand gemäß Anspruch 1 oder 2, wobei das thermoplastische Harz der primären Seite einen anorganischen Füllstoff enthält.

4. Zweifarbiger geformter Gegenstand gemäß einem der vorangehenden Ansprüche, wobei das thermoplastische Harz der sekundären Seite 0,1 bis 10 Gew.-% (bezogen auf die Gesamtzusammensetzung) eines Silikonkautschuks und/oder eines thermoplastischen Elastomers enthält.

5. Zweifarbiger geformter Gegenstand gemäß Anspruch 4, wobei das thermoplastische Harz der sekundären Seite einen pulverartigen oder teilchenförmigen Silikonkautschuk enthält.

6. Zweifarbiger geformter Gegenstand gemäß Anspruch 5, wobei das thermoplastische Harz der sekundären Seite Silikonkautschuk mit einem mittleren Teilchendurchmesser von 0,1 bis 100 »m enthält.

7. Zweifarbiger geformter Gegenstand gemäß Anspruch 4, wobei das thermoplastische Harz der sekundären Seite ein thermoplastisches Elastomer enthält, das aus Ethylen/Ethylacrylat-Copolymerharzen, Ethylen/Ethylacrylat-Copolymerharzen mit aufgepfropftem Maleinsäureanhydrid, Nylon-4,6 und Polyamidharzelastomeren ausgewählt ist.

8. Zweifarbiger geformter Gegenstand gemäß einem der vorangehenden Ansprüche, wobei der geformte Gegenstand der primären Seite zum Plattieren vorbehandelt ist.

9. Zweifarbiger geformter Gegenstand gemäß einem der vorangehenden Ansprüche, wobei der Flüssigkristallpolyester aus einem aromatischen Polyester, einem aromatischen Polyesteramid und einem Polyester, der partiell sowohl einen aromatischen Polyester als auch ein aromatisches Polyesteramid in demselben Molekül umfaßt, ausgewählt ist.

10. Zweifarbiger geformter Gegenstand gemäß Anspruch 9, wobei der Flüssigkristallpolyester ein aromatischer Flüssigkristallpolyester oder ein aromatisches Flüssigkristallpolyesteramid ist und wenigstens eine Verbindung enthält, die aus der Gruppe ausgewählt ist, die aus einer aromatischen Hydroxycarbonsäure, einem aromatischen Hydroxyamin und einem aromatischen Diamin besteht.

## Revendications

1. Article moulé à deux couleurs utilisable pour la réalisation de circuits, formé par le procédé de moulage par injection à deux couleurs consistant à mouler, d'un seul tenant, une résine thermoplastique de face secondaire contenant une charge inorganique avec l'article moulé en résine thermoplastique de face principale comprenant une composition de résine qui s'étale facilement, caractérisé en ce qu'une composition de résine de polyester ayant les propriétés d'un cristal liquide contenant un polyester ayant les propriétés d'un cristal liquide de poids moléculaire moyen de 10000 ou moins comme résine de base et ayant une viscosité à l'état fondu (à une température de 310°C et à un taux de cisaillement de 1200^{s-1}) de 200 P ou moins, est utilisé comme résine thermoplastique de face secondaire, ceci donnant une excellente adhérence entre l'article moulé de la résine thermoplastique de face principale et la résine thermoplastique de face secondaire.

2. Article moulé à deux couleurs selon la revendication 1, dans lequel la résine thermoplastique de face principale est choisie parmi les polyesters ayant les propriétés d'un cristal liquide, les polysulfones, les polyéther sulfones, les polyéthers imides, les sulfures de polyphénylène et les polyéthers cétones.

3. Article moulé à deux couleurs selon la revendication 1 ou la revendication 2, dans lequel la résine thermoplastique de face principale contient une charge inorganique.

4. Article moulé à deux couleurs selon l'une quelconque des revendications précédentes, dans lequel la résine thermoplastique de face secondaire contient 0,1 à 10 % en poids (par rapport à la composition totale) d'un caoutchouc de silicone et/ou d'un élastomère thermoplastique.

5. Article moulé à deux couleurs selon la revendication 4, dans lequel la résine thermoplastique de face secondaire contient un caoutchouc de silicone en poudre ou particulaire.

6. Article moulé à deux couleurs selon la revendication 5, dans lequel la résine thermoplastique de face secondaire contient un caoutchouc de silicone ayant un diamètre particulaire moyen de 0,1 à 100 »m.

7. Article moulé à deux couleurs selon la revendication 4, dans lequel la résine thermoplastique de face secondaire contient un élastomère thermoplastique choisi parmi les résines copolymères éthylène/acrylate d'éthyle, les résines copolymères éthylène/acrylate d'éthyle greffé par de l'anhydride maléique, les élastomères de Nylon 4,6 et de résine de polyamide.

8. Article moulé à deux couleurs selon l'une quelconque des revendications précédentes, dans lequel l'article moulé de face principale est un article traité pour l'électrodéposition.

9. Article moulé à deux couleurs selon l'une quelconque des revendications précédentes, dans lequel le polyester ayant les propriétés d'un cristal liquide est choisi parmi un polyester aromatique, un polyester amide aromatique et un polyester comprenant partiellement à la fois un polyester aromatique et un polyester amide aromatique dans la même molécule.

10. Article moulé à deux couleurs selon la revendication 9, dans lequel le polyester ayant les propriétés d'un cristal liquide est un polyester aromatique ou un polyester amide aromatique contenant au moins un composé choisi dans le groupe composé d'un acide hydroxy carboxylique aromatique, d'une hydroxy amine aromatique et d'une diamine aromatique.
